# EUROPEAN PATENT SPECIFICATION

(11) **EP 3 569 867 B1**
(45) Date of publication and mention of the grant of the patent: **06.10.2021**
(21) Application number: 19169327.4
(22) Date of filing: 15.04.2019
(51) Int. Cl.: F04D 29/28, F04D 29/30, F04D 25/06

(54) **CENTRIFUGAL FAN WITH ARC SHAPED BLADES**
RADIALLÜFTER MIT KREISBOGENFÖRMIGEN SCHAUFELN
VENTILATEUR CENTRIFUGE AVEC AUBES FORMÉES EN ARC DE CERCLE

(30) Priority: 28.04.2018 CN 201810404929
(43) Date of publication of application: 20.11.2019
(73) Proprietor: Cambricon Technologies Corporation Limited, Beijing 100191 (CN)
(72) Inventor: Li, Kun, Beijing, 100191 (CN); Wang, Dejing, Beijing, 100191 (CN); Xing, Shuo, Beijing, 100191 (CN)
(74) Representative: AWA Sweden AB

(56) References cited:
- GB-A- 276 998
- JP-A- 2006 329 097
- US-A1- 2002 182 079
- US-A1- 2003 053 911
- US-A1- 2007 116 561
- US-A1- 2010 254 086
- US-A1- 2012 057 971
- US-A1- 2013 319 641
- US-A1- 2015 003 974
- US-A1- 2016 025 107

## Description

### Technical Field

The present disclosure relates to the field of heat dissipation, and particularly relates to a board card turbo fan.

### Background

In recent years, the breakthrough in artificial intelligence has brought earth-shaking changes to the information industry. Accelerator cards based on ASIC chips and FPGA chips have achieved faster data acquisition, data processing, classification and prediction through a plurality of artificial intelligence algorithms, especially machine learning algorithms. The accelerator cards have achieved an order of magnitude reduction in computing time. Higher requirements are also placed on hardware computing power, but the improvements of computing power correspondingly increase power consumption of board cards. Limited contact area between heat dissipation structure of a board card and the external world puts forward higher requirements for air volume, wind pressure and low noise of a fan.

At present, there are two kinds of board card cooling fans: axial fans and turbo fans. Cooling performance of fans mainly depends on their air volume and wind pressure, while traditional turbo fans need to increase rotating speed of fans to increase air volume, thus exacerbating noise. In this case, large air volume and low noise may not be compromised at the same time.

GB 276 998 discloses one embodiment of a multi-blade fan. US 2012/0057971 discloses one embodiment of a centrifugal blower. US 2003/0053911 discloses one embodiment of a centrifugal ventilator fan. Furthermore, the documents JP 2006 329097 A, US 2007/116561 A1 and US 2015/003974 A1 disclose centrifugal fans for cooling electronic equipment.

### Summary

In view of this, it is necessary to provide a turbo fan to overcome the problem in traditional turbo fans being unable to simultaneously take large air volume and low noise into account.

A board card turbo fan with the features according to claim 1 is provided.

In one embodiment, the rotor housing includes:
an accommodation bucket, forming a fan rotor accommodation space around to accommodate fan rotors; and
an annular connecting plate fixedly connected to an outer edge of the accommodation bucket, and the fan blade structure arranged around the annular connecting plate and fixedly connected with the annular connecting plate.

In one embodiment, the accommodation bucket includes:
a top plate of accommodation bucket;
a side plate of accommodation bucket, arranged around an edge of the top plate of accommodation bucket and fixedly connected with the edge of the top plate of accommodation bucket, the annular connecting plate fixedly arranged at a side of the side plate of accommodation bucket away from the top plate of accommodation bucket.

In one embodiment, the accommodation bucket further includes a plurality of heat-dissipation holes arranged on a surface of the accommodation bucket.

In one embodiment, the turbo fan further includes an annular bracket arranged around the rotor housing, and the annular bracket is fixedly connected to the plurality of fan blades.

In one embodiment, the annular bracket is arranged at an end of the fan blade away from the annular connecting plate.

In one embodiment, the axis of the fan blade is perpendicular to the annular connection plate.

In one embodiment not forming part of the invention, the turbo fan further includes an installation chassis, the installation chassis and the rotor housing are oppositely and rotatably connected. The installation chassis includes an installation plate and a side panel arranged in a periphery of the installation plate, where the side panel and the installation plate form a groove around. The side panel is arranged with a wire passing groove.

In one embodiment not forming part of the invention, the turbo fan further includes a fan terminal, and the fan terminal includes:
a connecting arm, an end of the connecting arm fixedly connected to the side panel; and
a wire pressing arm, an end of the wire pressing arm fixedly connected to another end of the connecting arm away from the side panel and an other end of the wire pressing arm spaced with the side panel. The wire pressing arm and the connecting arm are located on the same plane as the installation plate. A surface of the wire pressing arm away from the rotor housing is arranged with a wire pressing groove, and the wire pressing groove is arranged corresponding with the wire passing groove.

In the following, the word "disclosure" simply means "what is disclosed" and not the invention. The invention is defined by the appended claims.

The embodiments of the present disclosure provide a turbo fan including a rotor housing and a fan blade structure connected with the rotor housing. The turbo fan arranges the fan blade with an arc-shaped cross section, and when the turbo fan rotates, the arc structure of the fan blade can push more air to increase air volume. Furthermore, since the arc length is 1/8-1/6 of the circumference of the circle where the arc is located, the fan blade has an appropriate radian, thus effectively reducing wind resistance and then effectively reducing noise and increasing air volume.

### Brief Description of the Drawings

Fig. 1 is a structural diagram of a turbo fan according to an embodiment of the present disclosure.
Fig. 2 is a top view of a turbo fan according to an embodiment of the present disclosure.
Fig. 3 is a diagram showing test effects of air volume and wind pressure of a turbo fan according to an embodiment of the present disclosure Fig. 4 is a partial enlargement diagram of circle A area in Fig. 2.
Fig. 5 is a top view of a turbo fan according to another embodiment of the present disclosure, not forming part of the invention.
Fig. 6 is a bottom view of a turbo fan according to an embodiment of the present disclosure not forming part of the invention.
Fig. 7 is a diagram of the exploded structure of a turbo fan according to an embodiment of the present disclosure not forming part of the invention.
Fig. 8 is a partial enlargement diagram of circle B area in Fig. 7 which embodiment is not forming part of the invention

### Description of reference numbers in the accompanied drawings:

- 10: Turbo Fan
- 100: Rotor Housing
- 110: Accommodation Bucket
- 112: Top Plate of Accommodation Bucket
- 114: Side Plate of Accommodation Bucket
- 116: Heat Dissipation Hole
- 120: Annular Connecting Plate
- 200: Fan Blade Structure
- 210: Fan Blade
- 212: Air Intake
- 214: Air Output
- 300: Annular Bracket
- 400: Installation Chassis
- 410: Installation Plate
- 420: Side panel
- 422: Wire Passing Groove
- 500: Fan Terminal
- 510: Connecting Arm
- 520: Wire Pressing Arm
- 522: Wire Pressing Groove

### Detailed Description of The Embodiments

To make the above purposes, features and advantages of the present disclosure clearer and easier to understand, specific embodiments of the present disclosure will be described in detail hereinafter with reference to the accompanied drawings. Details are described below to make the present disclosure fully understood. However, the present disclosure may be implemented in other ways and those skilled in the art can make similar improvements.

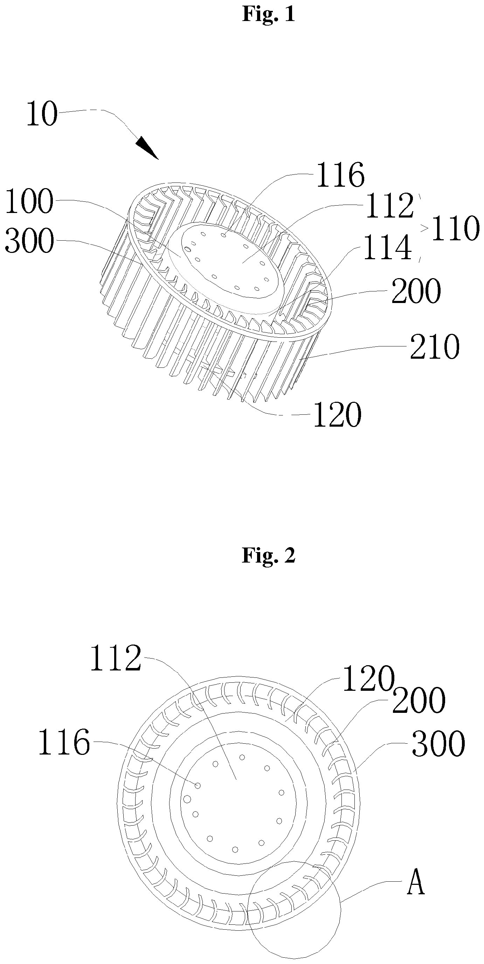

Referring to Fig. 1 and Fig. 2, the present disclosure provides a turbo fan 10 including a rotor housing 100 and a fan blade structure 200 arranged around the rotor housing 100. The fan blade structure 200 is fixed to the periphery of the rotor housing 100 and includes a plurality of fan blades 210 spaced and extending in the same direction. Alternatively, the plurality of fan blades 210 of the fan blade structure 200 are centrally symmetrical with respect to the axis of the rotor housing 100. The arc length of a cross section of the fan blade 210 is 1/8-1/6 of the circumference of the circle in which the arc is located. It is understandable that a central angle corresponding to the arc lie between 45 to 60 degrees. The shape of the fan blade 210 is a "tile" type and a cross section of the "tile" is an arc, the arc length is 1/8-1/6 of the circumference of the circle in which the arc is located. In one embodiment, the length of the arc is 1/7 of the circumference of the circle in which the arc is located.

In the present embodiment, the turbo fan 10 sets the fan blade 210 with an arc section, and when the turbo fan 10 rotates, the arc structure of the fan blade 210 can push more air to increase air volume. Meanwhile, since the length of the arc is 1/8-1/6 of the circumference of the circle where the arc is located, the fan blade 210 has an appropriate radian, thus effectively reducing wind resistance and then effectively reducing noise and increasing air volume.

The material of the rotor housing 100 is not limited as long as the shape can be maintained. Alternatively, the material of the rotor housing 100 can be a metal or chemical product. For example, the material of the rotor housing 100 can be aluminum or aluminum alloy. Alternatively, a section of the rotor housing 100 can be circular. The material of the fan blade 210 is not limited as long as the shape can be maintained. Alternatively, the material of the fan blade 210 can be a metal or a chemical product. For example, the material of the fan blade 210 can be aluminum or aluminum alloy. In one embodiment, the fan blade structure 200 is integrated with the rotor housing 100, thus the overall structure is more stable.

In one embodiment, the rotor housing 100 includes an accommodation bucket 110 and an annular connecting plate 120 fixedly connected with the outer edge of the accommodation bucket 110, where the accommodation bucket 110 forms a fan rotor accommodation space around to accommodate fan rotors, and the fan blade structure 200 is arranged around the annular connecting plate120 and fixedly connected with the annular connecting plate 120. Alternatively, the fan blade structure 200 can be spaced with the accommodation bucket 110. Alternatively, the fan blade structure 200 can be fixedly connected to the accommodation bucket 110.

Alternatively, the annular connection plate 120 is perpendicular to the axis of the accommodation bucket 110. Alternatively, a connection between the annular connecting plate 414 and the accommodation bucket 412 is arranged in an arc shape, thereby reducing wind resistance and noise. In one embodiment, the accommodation bucket 412 is integrated with the annular connecting plate 414, and the structure is stable.

Alternatively, the accommodation bucket 110 includes a top plate of accommodation bucket 112 and a side plate of accommodation bucket 114. The side plate of accommodation bucket 114 is arranged around the edge of the top plate of accommodation bucket 112 and fixedly connected to the edge of the top plate of accommodation plate 112. The annular connecting plate 120 is fixedly arranged at one side of the side plate of accommodation bucket 114, and the side is away from the top plate of accommodation bucket 112. When the turbo fan 10 rotates, air current flows through the side plate of accommodation bucket 114 from the top plate of accommodation bucket 112 to the annular connecting plate 120.

In one embodiment, the accommodation bucket 110 further includes a plurality of heat-dissipation holes 116 and the plurality of heat-dissipation holes 116 are arranged at the surface of the accommodation bucket 110. Alternatively, the plurality of heat-dissipation holes 116 may be disposed on the top plate of accommodation bucket 112, thus dissipating heat generated by rotors in the rotor housing 100 faster. Alternatively, the plurality of heat-dissipation holes 116 may be disposed on the side plate of accommodation bucket 114. In one embodiment, the heat-dissipation holes 116 can be equally spaced and the shape of the heat-dissipation holes 116 is not limited. Alternatively, the shape of the heat-dissipation holes 116 may be circular or polygonal. Specifically, the shape of the heat-dissipation holes 116 may be triangle, quadrilateral or hexagon. In the present embodiment, the heat-dissipation holes 116 may be through holes that penetrate the inner part of the rotor housing 410 to facilitate dissipating heat from rotors.

In one embodiment, the turbo fan 10 further includes an annular bracket 300 arranged around the rotor housing 100. The annular bracket 300 is fixedly connected with the plurality of fan blades 210. Alternatively, the annular bracket 300 is fixedly connected with all the fan blades 200 within the fan blade structure 210. Alternatively, the annular bracket 300 is integrated with the fan blade structure 200. In the present embodiment, the annular bracket 300 makes the fan blade structure 200 more stable and avoids noise caused by the shaking of the fan blade 210.

In one embodiment, the annular bracket 300 is arranged at an end of the fan blade 210 away from the annular connecting plate 120. The two ends of the fan blade 210 in the vertical direction of the annular connecting plate 120 are respectively fixed, so as to make the fan blade structure 200 more stable and avoid noise caused by the shaking of the fan blade 210.

According to the invention, the diameter of a circle in which an arc-shaped cross section of the fan blade 210 is located is 1/10-1/6 of an outer diameter of the fan blade structure 200. As an example, the diameter of the circle in which the arc-shaped cross section of the fan blade 210 is located may be 1/9 of the outer diameter of the fan blade structure 200. As a further example, the diameter of the circle in which the arc-shaped cross section of the fan blade 210 is located may be 1/8 of the outer diameter of the fan blade structure 200. As a further example, the diameter of the circle in which the arc-shaped cross section of the fan blade 422 is located may be 1/7 of the outer diameter of the fan blade structure 200. In one embodiment, the diameter of the circle in which the arc-shaped cross section of the fan blade 210 is located can be 6.6mm, the outer diameter of the fan blade structure 420 can be 66 mm.

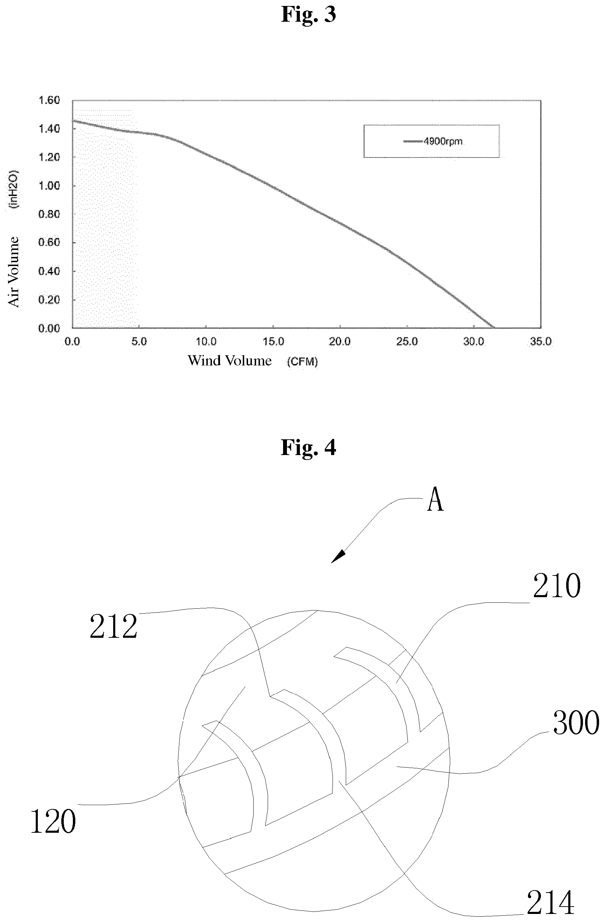

In the present embodiment, the size of the fan blade 210 is in proportion to that of the turbo fan 10 and the overall compatibility is better, so that the condition of air inlet and air outlet is more balanced. In this case, the air volume and wind pressure at the air outlet of the turbo fan 10 can achieve an ideal result (see Fig. 3). In one embodiment, the rotational speed of the turbo fan 10 can be 4900 rpm.

In one embodiment, the axis of the fan blade 210 along the longitudinal direction of the fan blade can be perpendicular to the annular connection plate 120. It is understandable that the fan blade 210 is integrally perpendicular to the annular connecting plate 120, so that the outlet direction of the turbo fan 10 is parallel to the annular connecting plate 120. Alternatively, the fan blade 210 can be inclined to the surface of the annular connection plate 120. The arc-shaped fan blade 210 has a recess surface and a projection surface opposite to the recess surface. When an angle between the recess surface of the fan blade 210 and a surface of annular connecting plate 120 near the top plate of accommodation bucket 112 is acute, the outlet direction of the turbo fan 10 is concentrated in the direction close to the annular connecting plate 120. When the angle between the recess surface of the fan blade 210 and a surface of annular connecting plate 120 near the top plate of accommodation bucket 112 is obtuse, the outlet direction of the turbo fan 10 is concentrated in the direction away from the annular connecting plate 120.

Referring to Fig. 4, in one embodiment, the two ends of the arc of the fan blade are an air inlet 212 arranged near the rotor housing 200 and an air outlet 214 away from the air inlet 212 respectively, where the air inlet 212 is blade-shaped. The air current generated by rotation of the turbo fan 10 flows into the fan blade structure 200 from the air inlet 212 and flows out of the fan blade structure 200 from the air outlet 214. The air inlet 212 is configured to intercept the air current entering the fan blade structure 200 during the rotation of the fan blade structure 200. In the present embodiment, the air inlet 212 is arranged to be blade-shaped to reduce wind resistance and facilitate intercepting air current, thereby reducing noise.

According to the invention, an angle between a tangential line of the arc at the air outlet 214 and a tangent line of the fan blade structure 200 at the air outlet 214 is acute and has the value of 45 degrees.

The angle between a tangential line of the arc at the air outlet 214 and a tangent line of the fan blade structure 200 at the air outlet 214 is acute such that the axis of the fan blade 210 is close to the axis of the rotor housing 200. The fan blade 210 with such an angle may facilitate the air current to be generated and accelerated by the fan blade 210, thus accelerating outflow speed and increasing air volume.

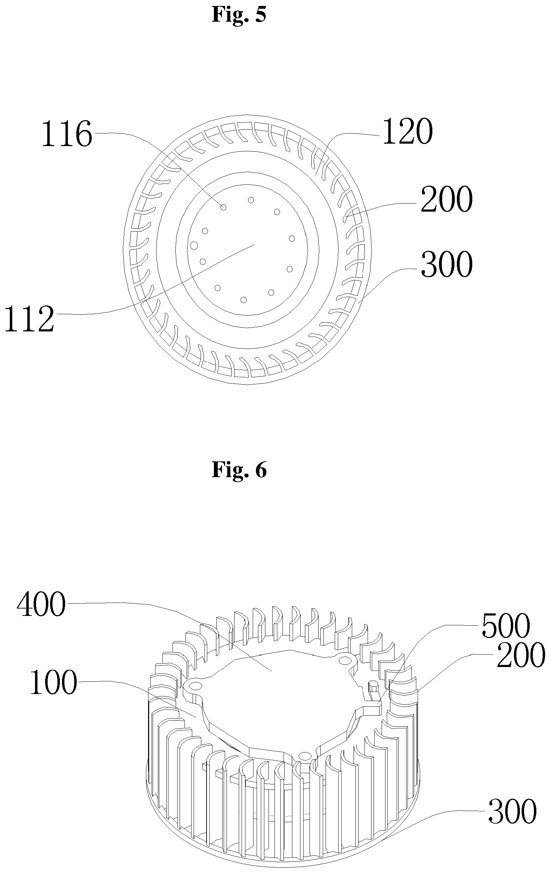

Referring to Fig. 5, in one embodiment, the annular bracket 300 is arranged at the air outlet 214 and the end of the fan blade 210 away from the annular connecting plate 120. When the air current flows out, the annular bracket 300 can act as a barrier to prevent the air current from flowing away from the annular connecting plate 120. In one embodiment which does not form part of the invention, the air outlet 214 is perpendicular to a tangent line of the outer edge of the fan blade structure 200 at the air outlet 214 to facilitate the air in the turbo fan 10 to flow out.

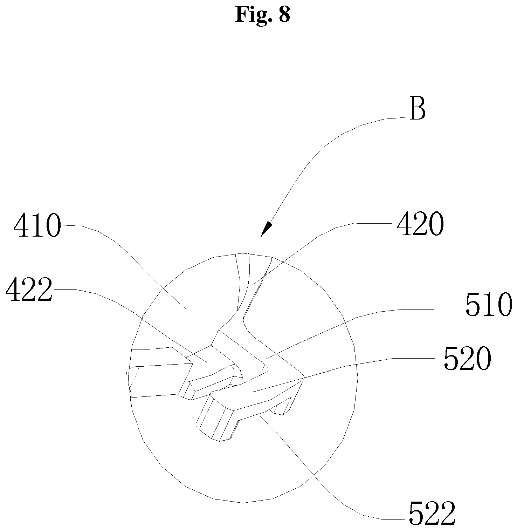

Referring to Fig. 6, in one embodiment not forming part of the invention, the turbo fan 10 further includes an installation chassis 400, and the installation chassis 400 and the rotor housing 100 are oppositely and rotatably connected. The installation chassis 400 includes an installation plate 410 and a side panel 420 arranged in the periphery of the installation plate 410, where the side panel 420 and the installation plate 410 form a groove. As shown in Fig. 8, the side panel 420 is arranged with a wire passing groove 422.

In one embodiment, the installation chassis 400 is fixedly installed on an installation surface. The installation chassis 400 and the installation surface can be fixedly connected by screws. Specifically, three screw holes are equally spaced in the periphery of the installation chassis 400, and the installation chassis 400 is connected with the installation surface by screws passed through the screw holes. The material of the installation chassis 400 is not limited as long as the shape can be maintained. Alternatively, the installation chassis 400 may be metal. Specifically, the installation chassis 400 can be aluminum or aluminum alloy to facilitate heat dissipation of the turbo fan 10. The shape of the installation chassis 400 is not limited. In one embodiment, the shape of the installation chassis 400 can be a circular plate or a polygonal plate.

In one embodiment, a plurality of cutting edges are spaced in the side panel 420 to make the installation chassis 400 irregularly circular, thus avoiding the problem that the installation chassis 400 cannot be installed due to a size error during the production process. In one embodiment, the side panel 420 is perpendicular to the installation plate 410. The groove formed by the side panel 420 and the installation plate 442 is configured to accommodate rotors and the wire passing groove 422 is configured to allow wires connecting the rotors to pass through for assembly. The installation chassis 400 is arranged with a shaft at the axis on the side of the rotor housing 100, and a fan rotor is installed on the shaft and can rotate around the shaft.

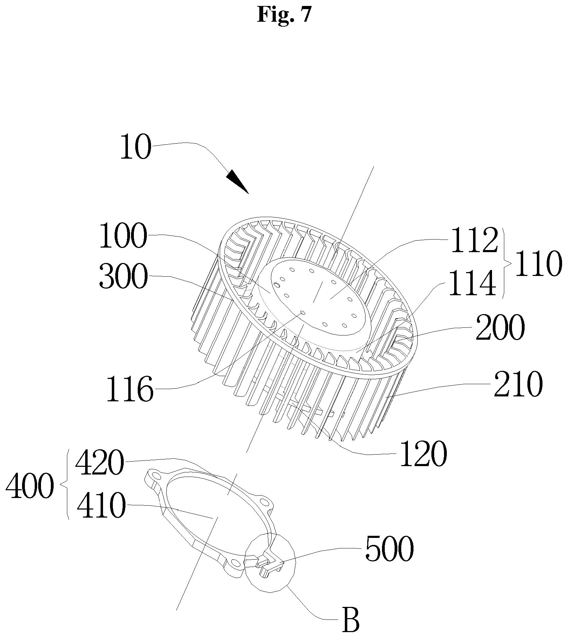

Referring to Fig. 6 and Fig. 7, in one embodiment, the turbo fan 10 further includes a fan terminal 500, and the fan terminal 500 is configured to protect connecting wires of the turbo fan 10. The fan terminal 500 includes a connecting arm 510 and a wire pressing arm 520. An end of the connecting arm 510 is fixedly connected with the side panel 420, which is fixedly connected with the end of the connecting arm 510 away from the side panel 420, and the other end of the connecting arm 510 is spaced with the side panel 420. The wire pressing arm 520 and the connecting arm 510 are located on the same plane as the installation plate 420. A surface of the wire pressing arm 520 away from the rotor housing 100 is arranged with a wire pressing groove 522, and the wire pressing groove 522 is arranged corresponding with the wire passing groove 422.

In one embodiment, the wire pressing arm 520 forms an L-shape with the connecting arm 510. Alternatively, the shape of the fan terminal 500 can also be annular. An interval between the wire pressing arm 520 and the side panel 420 forms an opening, and the opening facilitates the connecting wires to pass through and then enter the fan terminal 500. The wire pressing groove 522 can form an interval between the fan terminal 500 and the base 100 so as to facilitate the connecting wires to pass through. In one embodiment, the fan terminal 500 is integrated with the installation chassis 400. In one embodiment, the fan terminal 500 is as thick as the installation chassis 400.

In the present embodiment, the connecting wires are led from the wire passing groove 422 to the wire pressing groove 522 and are then led out, so as to protectively enclose the connecting wires and avoid influencing the connecting wires when the turbo fan 10 rotates, thus preventing interference.

The described embodiments merely introduce some implementations of the present disclosure and the description is specific, but the embodiments should not be considered as limitations to the scope of the present invention, which is defined by the appended claims.

## Claims

1. A board card turbo fan, comprising:
a rotor housing (100); and
a fan blade structure (200) arranged around the rotor housing (100) and fixed to a periphery of the rotor housing (100), and the fan blade structure (200) comprising a plurality of fan blades (210) spaced and extending inward towards a central axis of the rotor housing (100), wherein
a cross section of the fan blade (210) as seen in a plane that is orthogonal to the central axis of the rotor housing (100) is a circular arc and a length of the arc is 1/8-1/6 of a circumference of a circle in which the arc is located, and
wherein a first end of the arc of the fan blade (210) is an air inlet (212) arranged near the rotor housing (100) and a second end of the arc of the fan blade (210) is an air outlet (214) facing away from the air inlet (212),
the board card turbo fan being **characterized in that** a diameter of a circle in which the arc-shaped cross section of the fan blade (210) is located is 1/10-1/6 of an outer diameter of the fan blade structure (200), and **in that**, as seen in a plane that is orthogonal to the axis of the rotor housing, an angle between
- a part of a line which is tangential to the arc at the air outlet (214) and which starts from the air outlet (214) and extends away from the axis of the rotor housing (100), and
- a part of a line which is tangential to the fan blade structure (200) at the air outlet (214) and which starts from the air outlet (214) and extends in a rotation direction of the turbo fan,
is an acute angle, so that the axis of the fan blade (210) is close to the axis of the rotor housing (100), and this acute angle has a magnitude of 45 degrees.

2. The board card turbo fan of claim 1, wherein the rotor housing (100) comprises:
an accommodation bucket (110), forming a fan rotor accommodation space around to accommodate a fan rotor; and
an annular connecting plate (120) fixedly connected with an outer edge of the accommodation bucket (110), and the fan blade structure (200) arranged around the annular connecting plate (120) and fixedly connected with the annular connecting plate (120).

3. The board card turbo fan of claim 2, wherein the accommodation bucket (110) comprises:
a top plate (112); and
a side plate (114) arranged around the edge of the top plate (112) and fixedly connected with an edge of the top plate (112), wherein the annular connecting plate (120) is fixedly arranged at a side of the side plate (114) away from the top plate (112) .

4. The board card turbo fan of claim 2, wherein the accommodation bucket (110) further comprises a plurality of heat-dissipation holes (116) arranged on a surface of the accommodation bucket (110).

5. The board card turbo fan of claim 1, wherein the turbo fan (10) further comprises an annular bracket (300) arranged around the rotor housing (100), and the annular bracket (300) is fixedly connected with the plurality of fan blades (210).

6. The board card turbo fan of claim 5, wherein the annular bracket (300) is arranged at an end of the fan blade (210) away from the annular connecting plate (120).

7. The board card turbo fan of claim 2, wherein the axis of the fan blade (210) along the longitudinal direction of the fan blade (210) is perpendicular to the annular connection plate (120).

## Patentansprüche

1. Platinenkarte-Turbogebläse, umfassend:
ein Rotorgehäuse (100) und
eine Gebläseschaufelstruktur (200), die um das Rotorgehäuse (100) herum angeordnet und an einem Umfang des Rotorgehäuses (100) befestigt ist, wobei die Gebläseschaufelstruktur (200) eine Vielzahl von beabstandeten Gebläseschaufeln (210) umfasst, die sich nach innen zu einer mittleren Achse des Rotorgehäuses (100) erstrecken, wobei
ein Querschnitt der Gebläseschaufel (210), in einer orthogonal zu der mittleren Achse des Rotorgehäuses (100) verlaufenden Ebene gesehen, ein Kreisbogen ist und eine Länge des Bogens 1/8 - 1/6 eines Umfangs eines Kreises ist, in dem der Bogen angeordnet ist, und
wobei ein erstes Ende des Bogens der Gebläseschaufel (210) ein Lufteinlass (212) ist, der in der Nähe des Rotorgehäuses (100) angeordnet ist, und ein zweites Ende des Bogens der Gebläseschaufel (210) ein Luftauslass (214) ist, der von dem Lufteinlass (212) weg weist, wobei das Platinenkarte-Turbogebläse **dadurch gekennzeichnet ist, dass** ein Durchmesser eines Kreises, in dem der bogenförmige Querschnitt der Gebläseschaufel (210) angeordnet ist, 1/10 - 1/6 eines Außendurchmessers der Gebläseschaufelstruktur (200) ist,
und dass, in einer orthogonal zu der Achse des Rotorgehäuses verlaufenden Ebene gesehen, ein Winkel zwischen
- einem Teil einer Linie, die tangential zu dem Bogen an dem Luftauslass (214) verläuft und die an dem Luftauslass (214) beginnt und sich von der Achse des Rotorgehäuses (100) weg erstreckt, und
- einem Teil einer Linie, die tangential zu der Gebläseschaufelstruktur (200) an dem Luftauslass (214) verläuft und die an dem Luftauslass (214) beginnt und sich in eine Rotationsrichtung des Turbogebläses erstreckt,
ein spitzer Winkel ist, so dass die Achse der Gebläseschaufel (210) nahe der Achse des Rotorgehäuses (100) ist, und dieser spitze Winkel eine Größe von 45 Grad hat.

2. Platinenkarte-Turbogebläse nach Anspruch 1, wobei das Rotorgehäuse (100) Folgendes umfasst:
einen Aufnahmebecher (110), der einen Gebläserotoraufnahmeraum zur Aufnahme eines Gebläserotors bildet, und
eine ringförmige Verbindungsplatte (120), die fest mit einem äußeren Rand des Aufnahmebechers (110) verbunden ist, wobei die Gebläseschaufelstruktur (200) um die ringförmige Verbindungsplatte (120) angeordnet und fest mit der ringförmigen Verbindungsplatte (120) verbunden ist.

3. Platinenkarte-Turbogebläse nach Anspruch 2, wobei der Aufnahmebecher (110) Folgendes umfasst:
eine obere Platte (112) und
eine Seitenplatte (114), die um den Rand der oberen Platte (112) angeordnet und fest mit einem Rand der oberen Platte (112) verbunden ist, wobei die ringförmige Verbindungsplatte (120) fest an einer Seite der Seitenplatte (114) von der oberen Platte (112) weg angeordnet ist.

4. Platinenkarte-Turbogebläse nach Anspruch 2, wobei der Aufnahmebecher (110) ferner eine Vielzahl von Wärmeabfuhrlöchern (116) umfasst, die an einer Oberfläche des Aufnahmebechers (110) angeordnet sind.

5. Platinenkarte-Turbogebläse nach Anspruch 1, wobei das Turbogebläse (10) ferner eine ringförmige Halterung (300) umfasst, die um das Rotorgehäuse (100) herum angeordnet ist, und wobei die ringförmige Halterung (300) fest mit der Vielzahl von Gebläseschaufeln (210) verbunden ist.

6. Platinenkarte-Turbogebläse nach Anspruch 5, wobei de ringförmige Halterung (300) an einem Ende der Gebläseschaufel (210) weg von der ringförmigen Verbindungsplatte (120) angeordnet ist.

7. Platinenkarte-Turbogebläse nach Anspruch 2, wobei die Achse der Gebläseschaufel (210) entlang der Längsrichtung der Gebläseschaufel (210) senkrecht zu der ringförmigen Verbindungsplatte (120) verläuft.

## Revendications

1. Ventilateur centrifuge pour carte électronique, comprenant :
un logement de rotor (100) ; et
une structure à aubage de ventilateur (200) placée autour du logement de rotor (100) et fixée à une périphérie du logement de rotor (100), et la structure d'aubage de ventilateur (200) comprenant une pluralité d'aubes de ventilateur (210) espacées et s'étendant vers l'intérieur en direction d'un axe médian du logement de rotor (100), une section transversale de l'aube de ventilateur (210), vue dans un plan perpendiculaire à l'axe médian du logement de rotor (100), étant un arc de cercle et une longueur de l'arc étant égale à 1/8 à 1/6 d'une circonférence d'un cercle dans lequel l'arc est situé, et
une première extrémité de l'arc de l'aube de ventilateur (210) étant une entrée d'air (212) placée à proximité du logement de rotor (100) et une seconde extrémité de l'arc de l'aube de ventilateur (210) étant une sortie d'air (214) orientée dans une direction opposée à l'entrée d'air (212)
le ventilateur centrifuge de carte électronique étant **caractérisé en ce qu'**un diamètre d'un cercle dans lequel la section transversale en forme d'arc de l'aube de ventilateur (210) est située est égal à 1/10 à 1/6 d'un diamètre extérieur de la structure à aubage de ventilateur (200), et **en ce que**, vu dans un plan perpendiculaire à l'axe du logement de rotor, un angle entre
- une partie d'une ligne qui est tangente à l'arc au niveau de la sortie d'air (214) et qui commence à la sortie d'air (214) et s'étend dans une direction opposée à l'axe du logement de rotor (100), et
- une partie d'une ligne qui est tangente à la structure d'aubage de ventilateur (200) au niveau de la sortie d'air (214) et qui commence à la sortie d'air (214) et s'étend dans une direction de rotation du ventilateur centrifuge,
est un angle aigu, de telle sorte que l'axe de l'aube de ventilateur (210) est proche de l'axe du logement de rotor (100), et cet angle aigu a une grandeur de 45 degrés.

2. Ventilateur centrifuge pour carte électronique selon la revendication 1, dans lequel le logement de rotor (100) comprend :
un compartiment de réception (110), formant autour un espace de réception de rotor de ventilateur destiné à recevoir un rotor de ventilateur ; et
une plaque de raccordement annulaire (120) raccordée de manière fixe avec un bord extérieur du compartiment de réception (110), et la structure d'aubage de ventilateur (200) étant placée autour de la plaque de raccordement annulaire (120) et raccordée de manière fixe avec la plaque de raccordement annulaire (120).

3. Ventilateur centrifuge pour carte électronique selon la revendication 2, dans lequel le compartiment de réception (110) comprend :
une plaque supérieure (112) ; et
une plaque latérale (114) placée autour du bord de la plaque supérieure (112) et raccordée de manière fixe avec un bord de la plaque supérieure (112), la plaque de raccordement annulaire (120) étant placée de manière fixe sur un côté de la plaque latérale (114) opposé à la plaque supérieure (112).

4. Ventilateur centrifuge pour carte électronique selon la revendication 2, dans lequel le compartiment de réception (110) comprend en outre une pluralité de trous de dissipation de chaleur (116) placés sur une surface du compartiment de réception (110).

5. Ventilateur centrifuge pour carte électronique selon la revendication 1, le ventilateur centrifuge (10) comprenant en outre un support annulaire (300) placé autour du logement de rotor (100), et le support annulaire (300) étant raccordé de manière fixe avec la pluralité d'aubes de ventilateur (210).

6. Ventilateur centrifuge pour carte électronique selon la revendication 5, dans lequel le support annulaire (300) est placé à une extrémité de l'aube de ventilateur (210) opposée à la plaque de raccordement annulaire (120).

7. Ventilateur centrifuge pour carte électronique selon la revendication 2, dans lequel l'axe de l'aube de ventilateur (210) le long de la direction longitudinale de l'aube de ventilateur (210) est perpendiculaire à la plaque de raccordement annulaire (120).
